(19) Europäisches Patentamt European Patent Office Office européen des brevets

(11) **EP 4 307 870 B1**

(12) **EUROPEAN PATENT SPECIFICATION**

(45) Date of publication and mention of the grant of the patent:
**23.04.2025 Bulletin 2025/17**

(21) Application number: **23182046.5**

(22) Date of filing: **28.06.2023**

(51) International Patent Classification (IPC):
**H10N 30/076** (2023.01)      **H10N 30/853** (2023.01)
**H10N 30/87** (2023.01)

(52) Cooperative Patent Classification (CPC):
**H10N 30/708; H10N 30/076; H10N 30/8554;**
**H10N 30/877**

(54) **PIEZOELECTRIC LAMINATE AND PIEZOELECTRIC ELEMENT**

PIEZOELEKTRISCHES LAMINAT UND PIEZOELEKTRISCHES ELEMENT

STRATIFIÉ PIÉZOÉLECTRIQUE ET ÉLÉMENT PIÉZOÉLECTRIQUE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **13.07.2022 JP 2022112632**

(43) Date of publication of application:
**17.01.2024 Bulletin 2024/03**

(73) Proprietor: **FUJIFILM Corporation**
**Tokyo 106-8620 (JP)**

(72) Inventors:
• **KOBAYASHI, Hiroyuki**
  **Kaisei-machi, Kanagawa 258-8577 (JP)**
• **NAKAMURA, Seigo**
  **Kaisei-machi, Kanagawa 258-8577 (JP)**

(74) Representative: **HGF**
**HGF Limited**
**1 City Walk**
**Leeds LS11 9DX (GB)**

(56) References cited:
**EP-A1- 3 159 428        EP-A1- 4 142 455**
**US-A1- 2009 114 875    US-A1- 2016 005 950**
**US-A1- 2018 254 406    US-A1- 2019 157 542**

• **LIU GUO-YING; LIU-QING; LUO SHI-JUN: "Effect of Co and Nb codoping on electrical properties of PZT ferroelectric thin films", ELECTRONIC COMPONENTS & MATERIALS, vol. 25, no. 8, 1 August 2006 (2006-08-01), pages 33 - 35, XP009550031, ISSN: 1001-2028**

**Description**

BACKGROUND

1. Technical Field

The present invention relates to a piezoelectric laminate and a piezoelectric element.

2. Related Art

A piezoelectric film is applied in a piezoelectric element having a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and a vibration power generation device.

As a material having excellent piezoelectric characteristics, there is known a perovskite-type oxide based on lead zirconate titanate ($Pb(Zr, Ti)O_3$, (hereinafter referred to as PZT)). It is known that in a case of having a morphotropic phase boundary (MPB) composition in which Zr:Ti is in the vicinity of 52:48, the PZT-based perovskite-type oxide piezoelectric film has the highest piezoelectric constant and is suitable for a use application to an actuator.

In the related art, a piezoelectric strain (a normal electric field-induced strain), which extends in a spontaneous polarization axis in a case where an electric field is applied in a spontaneous polarization axis direction, has been used in a piezoelectric element. Further, a piezoelectric element, which has a domain in which a polarization axis can undergo reversible non-180° rotation by an increase or decrease of an electric field application in a direction different from the spontaneous polarization direction, has also been proposed in order to obtain a large displacement amount. In a case where a domain in a piezoelectric body undergoes non-180° domain rotation such as 90° domain rotation, a piezoelectric strain is generated. In a case of utilizing the reversible non-180° domain rotation, it is possible to obtain a much larger piezoelectric strain as compared with a case of using only the normal electric field-induced strain that extends in the polarization axis direction in a case where an electric field is applied in the spontaneous polarization direction of the piezoelectric body.

In a PZT-based perovskite-type oxide, in a case of adding niobium (Nb) as a B site element, it is possible to cause a domain to undergo the non-180° domain rotation, thereby obtaining a large piezoelectric strain associated with the non-180° domain rotation. In addition, it is also known that as the adding amount of Nb increases, the amount of piezoelectric strain associated with the non-180° domain rotation also tends to increase. However, in a case of increasing the amount of Nb added to PZT to a certain level or higher, there has been a problem that such a piezoelectric element cannot be used since an unusual phase having no piezoelectricity referred to as a pyrochlore phase is generated, or a film stress (an internal stress of a film) is increased and cracking occurs in the piezoelectric film.

On the other hand, WO2017/085924A or WO2018/042946A proposes that not only Nb is added to PZT but also nickel (Ni) or scandium (Sc) is added to the PZT. WO2017/085924A or WO2018/042946A shows that in a case of adding Ni or Sc, it is possible to suppress the pyrochlore phase that is generated in a case where the adding amount of Nb is increased.

On the other hand, WO2015/174265A discloses a method in which in an Nb-added PZT (hereinafter, referred to as Nb-PZT), the molar ratio of Nb is set in a range of 10% to 20%, the ratio of Zr is adjusted, and the film stress is set in a suitable range, whereby a piezoelectric film having high piezoelectric characteristics is realized. That is, WO2015/174265A realizes an increase in the adding amount of Nb by suppressing an increase in the film stress by adjusting the ratio of Zr. In addition, WO2015/174265A describes that in a case of providing a seed layer between the substrate and the piezoelectric film, it is possible to obtain a piezoelectric film having high crystallinity, and it is possible to obtain high piezoelectric characteristics.

US2009/0114875 A1 describes a piezoelectric element wherein the lower electrode may comprise a conductive oxide material like $SrRuO_3$ or $LaNiO_3$ and the piezoelectric PZT film has a distinct amount of La and Nb codoping on the A- and the B-site to increase the piezoelectric constant. US2016/0005950 A1 describes a PNN-PZT sample with high piezoelectric characteristics and EP3159428A1 describes a piezoelectric element comprising a conductive oxide material as seed layer.

SUMMARY

In WO2017/085924A and WO2018/042946A, it is shown that a high piezoelectric constant can be obtained in a PZT film to which Nb and Sc or Ni are added; however, the withstand voltage and the long-term stability have not been evaluated. According to the studies by the inventors of the present invention, there has been a case where the long-term stability of the piezoelectric element including the PZT film to which Nb and Sc or Ni are added is not sufficient.

According to the results of Examples and Comparative Examples of WO2015/174265A, a piezoelectric element having high piezoelectric characteristics is obtained. On the other hand, it cannot be said that the withstand voltage regarding Examples and Comparative Examples of WO2015/174265A is sufficient. In addition, the long-term stability has not been examined, and it is presumed that there is a high possibility that the long-term stability is not sufficient since the withstand voltage is low.

Considering a case of application to an actual device, it is not sufficient with the high piezoelectric characteristics alone, and high long-term stability is required.

The technique according to the present invention has been made in consideration of the above circumstances, and an object according to the present invention is to provide a piezoelectric laminate and a piezoelectric element, which have a piezoelectric film having high piezoelectric characteristics and high long-term stability.

Specific means for solving the above problems include the following aspects.

A piezoelectric laminate according to the present invention is defined by independent claim 1.

The seed layer is cubic crystalline or pseudo-cubic crystalline, and it preferably has a lattice constant of 0.4 nm or less.

The piezoelectric film preferably has crystal aligning properties in which crystals are preferentially aligned in a film thickness direction.

In the piezoelectric film, the internal stress is preferably a tensile stress in a range of 50 to 250 MPa.

The piezoelectric film preferably has a characteristic that a slope changes in electric field-strain characteristics in a case where an electric field of 0 kV/cm to 200 kV/cm is applied in a film thickness direction.

The seed layer is preferably $LaNiO_3$ or $SrRuO_3$.

The piezoelectric element according to the present invention has the piezoelectric laminate according to the present invention and an upper electrode layer formed on the piezoelectric film.

According to the present invention, it is possible to obtain a piezoelectric laminate and a piezoelectric element, which have a piezoelectric film having high piezoelectric characteristics and high long-term stability.

BRIEF DESCRIPTION OF THE DRAWINGS

Fig. 1 is a cross-sectional view illustrating a configuration of a piezoelectric laminate and a piezoelectric element, according to a first embodiment.

Fig. 2A is a view illustrating a state of a normal piezoelectric strain, and Fig. 2B is a view illustrating a state of a piezoelectric strain due to reversible non-180° domain rotation.

Fig. 3 is a view schematically illustrating a state of the non-180° domain rotation and an example of electric field-strain characteristics in an exemplary piezoelectric film.

Fig. 4 is a view schematically illustrating a state of the non-180° domain rotation and an example of electric field-strain characteristics in another exemplary piezoelectric film.

Fig. 5 is a view schematically illustrating an example of electric field-strain characteristics in a case of only a normal piezoelectric strain.

Fig. 6 is a graph showing measured values of the electric field-strain (displacement amount) characteristics for Example 4 and Comparative Example 6.

DESCRIPTION OF EMBODIMENTS

Hereinafter, embodiments of the present invention will be described with reference to the drawings. In the drawings below, the layer thickness of each of the layers and the ratio therebetween are appropriately changed and drawn for easy visibility, and thus they do not necessarily reflect the actual layer thickness and ratio. In the present specification, a numerical value range expressed using "to" means a range that includes the preceding and succeeding numerical values of "to" as the lower limit value and the upper limit value, respectively. Regarding numerical value ranges that are described stepwise in the present disclosure, an upper limit value or a lower limit value described in a numerical value range may be replaced with an upper limit value or a lower limit value of another stepwise numerical value range. In addition, regarding numerical value ranges described in the present disclosure, an upper limit value or a lower limit value described in a numerical value range may be replaced with a value described in Examples.

Piezoelectric laminate 5 and piezoelectric element 1

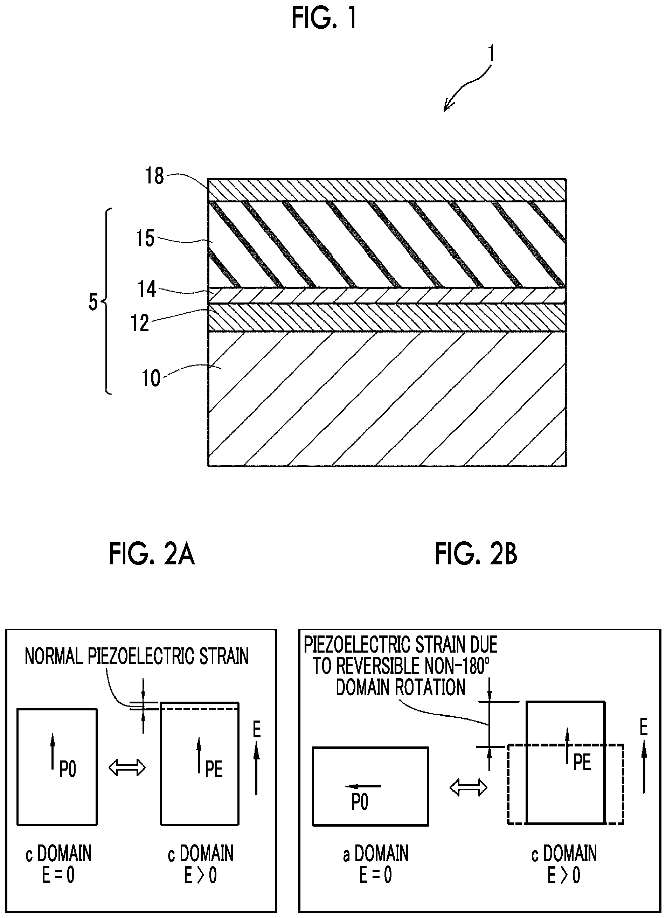

Fig. 1 is a cross-sectional view illustrating layer configurations of a piezoelectric laminate 5 and a piezoelectric element 1 having the piezoelectric laminate 5, according to a first embodiment. As illustrated in Fig. 1, the piezoelectric element 1 has the piezoelectric laminate 5 and an upper electrode layer 18. The piezoelectric laminate 5 has a substrate 10, a lower electrode layer 12, a seed layer 14, and a piezoelectric film 15 which are laminated on the substrate 10. The piezoelectric element 1 is configured such that an electric field is applied to the piezoelectric film 15 in the film thickness direction, by the lower electrode layer 12 and the upper electrode layer 18. Here, "lower" and "upper" do not respectively mean top and bottom in the vertical direction. As result, an electrode arranged on the side of the substrate 10 with the piezoelectric film 15 being interposed is merely referred to as the lower electrode layer 12, and an electrode arranged on the side of the piezoelectric film 15 opposite to the substrate 10 is merely referred to as the upper electrode layer 18.

The substrate 10 is not particularly limited, and examples thereof include substrates such as silicon, glass, stainless steel, yttrium-stabilized zirconia, alumina, sapphire, and silicon carbide. As the substrate 10, a laminated substrate having a $SiO_2$ oxide film formed on the surface of the silicon substrate, such as a thermal oxide film-attached silicon substrate, may be used.

The lower electrode layer 12 is an electrode for applying a voltage to the piezoelectric film 15. The main component of the lower electrode layer 12 includes a metal selected from gold (Au), platinum (Pt), iridium (Ir), titanium (Ti), molybdenum (Mo), tantalum (Ta), aluminum (Al), copper (Cu), silver (Ag), and combinations thereof. In particular, the main component of the lower electrode layer 12 is preferably from the platinum group, such as platinum (Pt) or iridium (Ir).

It is preferable to provide an intimate attachment layer (not illustrated in the drawing) containing titanium (Ti) or a titanium-tungsten (TiW) alloy as a main component, between the lower electrode layer 12 and the substrate 10.

The upper electrode layer 18 is paired with the lower electrode layer 12 and is an electrode for applying a voltage to the piezoelectric film 15. The main component of the upper electrode layer 18 is not particularly limited. Examples thereof include, in addition to the materials exemplified in the lower electrode layer 12, an electrode material generally used in a semiconductor process such as chromium (Cr), and a conductive oxide such as indium oxide (ITO: indium tin oxide), iridium oxide ($IrO_2$), ruthenium oxide ($RuO_2$), lanthanum nickel oxide ($LaNiO_3$), or strontium ruthenium oxide ($SrRuO_3$), and a combination thereof.

The thicknesses of the lower electrode layer 12 and the upper electrode layer 18 are not particularly limited, and they are preferably about 50 nm to 300 nm and more preferably 100 nm to 300 nm.

The seed layer 14 is a layer provided in order to increase the crystallinity of the piezoelectric film 15 that is provided on the seed layer 14. For the seed layer 14, any material can be used without limitation as long as it is a conductive oxide and has a function of increasing the crystallinity of the piezoelectric film 15 provided in the upper layer. The seed layer 14 is cubic crystalline or pseudo-cubic crystalline, where the lattice constant is preferably equal to or less than the lattice constant of the Nb-PZT system. Specifically, the lattice constant of the seed layer 14 is preferably 0.4 nm (= 4.0 Å) or less. Specific examples of the material of the seed layer 14 include $LaNiO_3$, $SrRuO_3$, and lanthanum-strontium cobalt oxide (La, Sr)$CoO_3$. It is noted that the lattice constant of $LaNiO_3$ is 3.84 Å, the lattice constant of $SrRuO_3$ is 3.905 Å, and the lattice constant of (La, Sr)$CoO_3$ is 3.84. The seed layer 14 is particularly preferably $LaNiO_3$ or $SrRuO_3$.

The piezoelectric film 15 contains a perovskite-type oxide represented by General Formula I.

$$Pb_{1-y2+\alpha}A_{y2}\{(Ti, Zr)_{1-x-y1}Nb_x B1_{y1}\}O_3 \qquad \text{General Formula I}$$

Here, A is an A site element, where it is one or more elements including at least La,

B1 is a B site element excluding Ti, Zr, and Nb, where it is one or more divalent or trivalent elements,
O is oxygen, and
x, y1, y2, and $\alpha$ satisfy
$0.05 < x \leq 0.3$, $0.2x \leq y1 + y2 \leq 0.5x$, $0 \leq y1 \leq 0.15$, $0 \leq y2 \leq 0.15$, and $0 \leq \alpha \leq 0.2$.

x indicates the adding amount of Nb at the B site, and "$0.05 < x \leq 0.3$" means that the molar ratio of Nb at the B site is 5% or more and 30% or less. In addition, x preferably satisfies $0.1 \leq x \leq 0.2$ and more preferably satisfies $0.15 \leq x \leq 0.2$.

y1 indicates the adding amount of the B1 element at the B site, and y2 indicates the adding amount of the A element at the A site. "$0.2x \leq y1 + y2 \leq 0.5x$" means that the element A and/or the element B1 is added to the A site and/or the B site in a range of 0.2x to 0.5x with respect to the adding amount x of Nb. It is preferable to satisfy $0.2x \leq y1 + y2 \leq 0.4x$, $0 \leq y1 \leq 0.12$, and $0 \leq y2 \leq 0.12$. It is noted that only the element A may be added, or only the element B1 may be added. Only the addition of the element A to the site A may be good, or only the addition of the element B1 to the B site may be good.

Regarding $Pb_{1-y2+\alpha}A_{y2}:(Ti, Zr)_{1-x-y1}Nb_x B1_{y1}:O_3$ in General Formula (1), a reference ratio is 1:1:3; however, the ratio may deviate therefrom within a range in which a perovskite-type structure is allowed to be formed.

In a case where $Pb_{1-y2+\alpha}A_{y2}:(Ti, Zr)_{1-x-y1}Nb_x B1_{y1}:O_3$ is 1:1:3, $\alpha$ is 0. Pb is an element that is easily subjected to reverse sputtering, and it adversely affects crystal growth in a case where Pb is removed from the piezoelectric film that has been formed into a film. Therefore, in many cases, the film formation is carried out by setting the amount of Pb of a target to be larger than the stoichiometric composition. In that case, the formed film may also be Pb-rich (that is, $\alpha > 0$) depending on the reverse sputtering rate of Pb. It is preferable that the molar ratio of Pb in the piezoelectric film 15 is equal to or larger than the stoichiometric composition from the viewpoint of obtaining a high-quality perovskite-type oxide film.

In general, examples of the B site element in the perovskite-type oxide represented by $ABO_3$ include scandium (Sc), titanium (Ti), zirconium (Zr), vanadium (V), niobium (Nb), tantalum (Ta), chromium (Cr), molybdenum (Mo), tungsten (W), manganese (Mn), Iron (Fe), ruthenium (Ru), cobalt (Co), iridium (Ir), nickel (Ni), Cu (copper), zinc (Zn), gallium (Ga), indium (In), tin (Sn), and antimony (Sb).

B1 includes one or more divalent or trivalent elements among the B site elements excluding Ti, Zr, and Nb. B1 is particularly preferably one or more of Sc, Co, and Ni.

It is said that the PZT-based perovskite-type oxide exhibits high piezoelectric characteristics at the morphotropic phase boundary (MPB) and in the vicinity thereof. In the PZT system, the MPB is formed in the vicinity of Zr/Ti molar ratio = 55/45. In the above-described general formula, the MPB composition or a vicinity thereof is preferable. "MPB or a vicinity thereof" is a region in which a phase transition occurs in a case where an electric field is applied to the piezoelectric film. Specifically, Zr:Ti (molar ratio) is preferably in a range of 45:55 to 55:45.

In the perovskite-type oxide represented by $ABO_3$, examples of the A site element include lead (Pb), barium (Ba), strontium (Sr), bismuth (Bi), lithium (Li), sodium (Na), calcium (Ca), cadmium (Cd), magnesium (Mg), potassium (K), and lanthanum (La).

A in General Formula I is one or more elements including at least lanthanum (La) among the A site elements excluding Pb.

In particular, it is preferable that A is La and B1 is one or more of Sc, Co, and Ni. Only one of La, Sc, Co, or Ni may be added, or a combination of two or more thereof may be added. In a case where, for example, only Sc is added among La, Sc, Co, and Ni, it suffices that B1 is the Sc element, and $y2 = 0$ and $0.2x \le y1 \le 0.5x$ are satisfied.

As described above, the perovskite-type oxide contained in the piezoelectric film 15 is a PZT-based perovskite-type oxide obtained by adding a predetermined adding amount of the element A and/or the element B1 as an additional element in the PZT to which Nb has been added (hereinafter, Nb-PZT).

It is noted that the content of the perovskite-type oxide in the piezoelectric film 15, which satisfies General Formula I, is preferably 80% by mole or more and more preferably 90% by mole or more. Further, it is particularly preferable that the piezoelectric film 15 is a perovskite-type oxide that satisfies General Formula I, excluding unavoidable impurities.

The thickness of the piezoelectric film 15 is generally 200 nm or more, and it is, for example, 0.2 $\mu$m to 5 $\mu$m. However, it is preferably 1 $\mu$m or more.

The piezoelectric film 15 preferably has crystal aligning properties in which crystals of the perovskite-type oxide are preferentially aligned in the film thickness direction. It is preferable that the crystals have a (001) plane alignment in which the tetragonal c-axis is aligned along the film thickness direction or a (100) plane alignment in which the tetragonal a-axis is aligned along the film thickness direction, or the crystals are subjected to a rhombohedral (111) plane alignment, where these plane alignments may be mixed.

It is noted that the presence or absence of crystal aligning properties can be checked according to X-ray diffraction by a general θ-2θ method. On the other hand, in a case of an Nb-PZT-based perovskite-type oxide having a morphotropic composition, the reflection peak positions of the tetragonal (001) plane, the tetragonal (100) plane, and the rhombohedral (111) plane overlap with each other in the X-ray diffraction by a general θ-2θ method, and thus it is almost impossible to distinguish them. In the present specification, "having crystal aligning properties in the film thickness direction" means that in a case where a ratio of a total of a tetragonal (001) plane peak, a tetragonal (100) plane peak, and a rhombohedral (111) plane peak to peaks from all reflecting surfaces, which are acquired according to the X-ray diffraction by a θ-2θ method, is defined as an alignment degree, the alignment degree is 80% or more. The alignment degree is preferably 90% or more.

In addition, in the piezoelectric film 15, the internal stress is preferably a tensile stress in a range of 50 to 250 MPa and more preferably 110 MPa to 220 MPa. In a case where the internal stress is in this range, it is possible to effectively suppress the occurrence of cracking in the piezoelectric film 15.

In the piezoelectric film 15, in a case where the polarization direction of the spontaneous polarization and the electric field application direction coincide with each other, it is possible to obtain both the effect of the normal piezoelectric strain, which expands and contracts in the electric field application direction due to an increase or decrease in the electric field application strength, and the piezoelectric strain due to the reversible non-180° domain rotation. In the piezoelectric strain due to the reversible non-180° domain rotation, a large strain is obtained by rotating the crystal lattice. Therefore, in a case of combining the normal piezoelectric strain and the piezoelectric strain due to the reversible non-180 domain rotation, it is possible to obtain a large piezoelectric strain as compared with the normal piezoelectric strain. As a result, the piezoelectric element 1 has high piezoelectric characteristics (a high piezoelectric constant).

Here, with reference to Fig. 2, the piezoelectric strain associated with the non-180° domain rotation that occurs in the piezoelectric film 15 will be described. Fig. 2A is a view illustrating a state of the normal piezoelectric strain. In Fig. 2, an arrow E indicates the electric field application direction, an arrow P0 indicates the polarization direction in a case where an electric field is not applied, and an arrow PE indicates the polarization direction in a case where an electric field is applied.

In a case where an electric field is applied (E > 0) in the polarization direction with respect to a c domain in which the c-axis is aligned in an electric field application direction (that is, the film thickness direction of the piezoelectric film), that is, subjected to a (001) plane alignment, the crystal lattice extends in the electric field application direction. This is the normal piezoelectric strain.

On the other hand, Fig. 2B illustrates a state of the piezoelectric strain due to the non-180° domain rotation. As illustrated in Fig. 2B, in a case where an a domain, in which the a-axis is aligned in the electric field application direction, that is, subjected to (100) plane alignment, is subjected to the 90° domain rotation to be the c domain in which the c-axis is aligned in the electric field application direction the application of the electric field (E > 0), the major axis direction of the crystal lattice is rotated by 90°, and a piezoelectric strain larger than the piezoelectric strain of Fig. 2A is obtained.

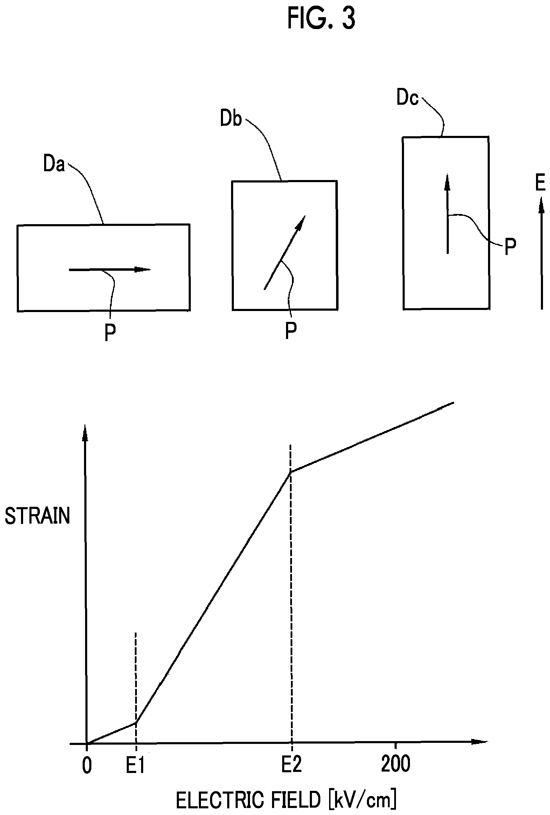

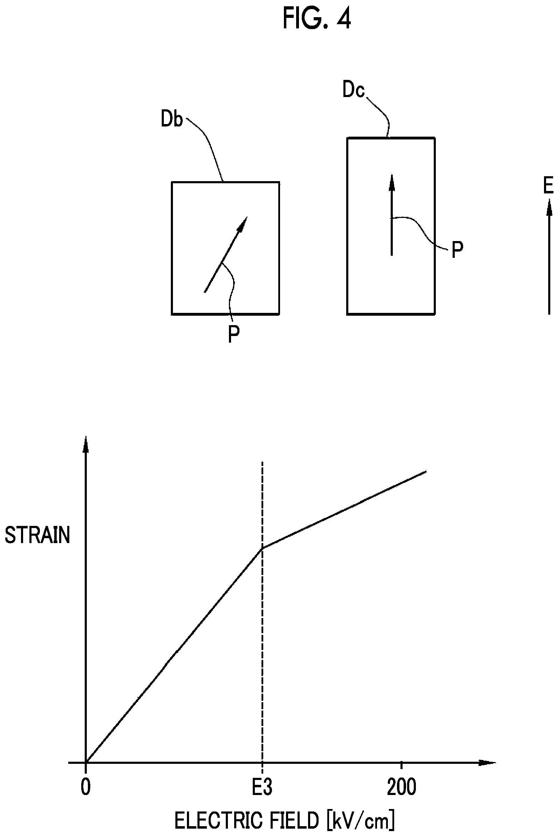

As described above, in a case where an electric field is applied in the film thickness direction, the piezoelectric film 15 of the present example exhibits a piezoelectric strain that is a combination of the piezoelectric strain due to the non-180° domain rotation and the normal piezoelectric strain. As a result, in a case where an electric field is applied in the film thickness direction, the piezoelectric film 15 of the present example has a characteristic that the slope changes in the electric field-strain characteristics as illustrated in Fig. 3 or Fig. 4.

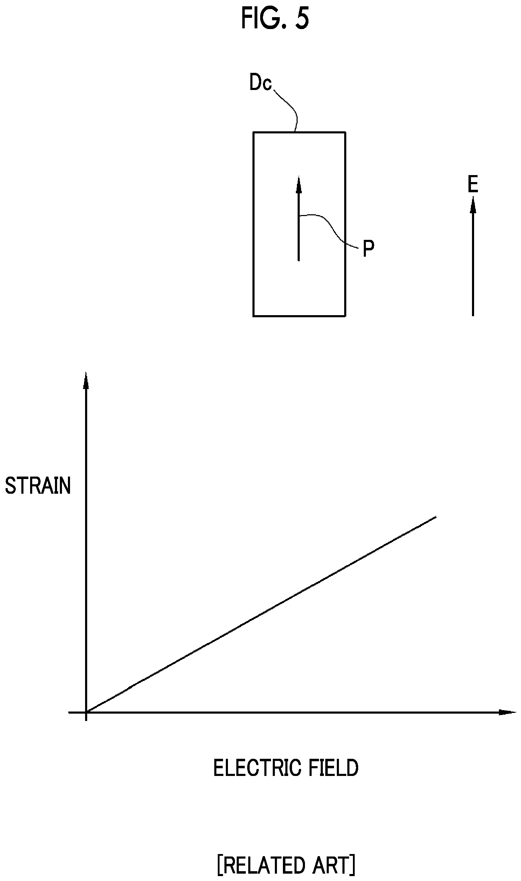

Fig. 3 shows a view showing a graph schematically showing an example of the electric field-strain characteristics of the piezoelectric film 15 and shows views schematically illustrating the non-180° domain rotation of the domain. In addition, Fig. 4 shows a view showing a graph schematically showing another example of the electric field-strain characteristics of the piezoelectric film 15 and shows views schematically illustrating the non-180° domain rotation of the domain. It is noted that Fig. 5 is a view, for comparison, which schematically illustrates electric field-strain characteristics in a piezoelectric film that does not generate the piezoelectric strain due to the non-180° domain rotation. In Fig. 3 to Fig. 5, the arrow E indicates the electric field application direction, and the arrow P indicates the polarization direction in each domain.

As illustrated in Fig. 5, in a case where the piezoelectric film is composed of a c domain Dc in which the c-axis is uniformly aligned in the electric field application direction, only the normal piezoelectric strain is generated since an electric field E is applied in the polarization direction P of the c domain Dc (see Fig. 2A). As shown in the graph in Fig. 5, the normal piezoelectric strain is proportional to the electric field, and the slope is constant.

In the piezoelectric film 15 of the present example, the element A and/or the element B1 is added to PZT in addition to Nb, and thus the (001) plane alignment is disturbed in the crystallinity, whereby the piezoelectric film 15 includes an a domain Da in addition to the c domain Dc. In this case, in the relationship between the electric field and the amount of strain, the slope changes in three stages, such as a slope from no electric field to E1, a slope from E1 to E2, and a slope after E2.

In a case where the piezoelectric film 15 includes the a domain Da together with the c domain Dc, a piezoelectric strain due to the non-180° domain rotation of the a domain Da is generated in addition to the normal piezoelectric strain generated in the c domain Dc in a case where the electric field E is applied in the thickness direction. Specifically, in a case of applying the electric field E in a direction perpendicular to the polarization direction in the a domain Da, the a domain Da is subjected to the 90° domain rotation, and a piezoelectric strain associated with the non-180° domain rotation is generated. In addition, after the rotation until the a domain Da becomes the c domain Dc by the application of the electric field, the electric field is applied in the polarization direction, and thus the normal piezoelectric strain is generated. It is noted that in a case where the a domain Da is subjected to the 90° domain rotation, it rotates to the c domain Dc via a rhombohedral domain Db. Since the amount of change until the rotation to the rhombohedral domain Db and the amount of change until the rotation from the rhombohedral domain Db to the c domain Dc are different from each other, the amount of change (the slope) in the amount of strain with respect to the electric field changes in three stages in Fig. 3. A domain rotation to the rhombohedral domain Db occurs at E1, and then a domain rotation to the c domain Dc occurs until E2. E2 is the electric field strength at which the rotation of the rotatable domain in the piezoelectric film 15 is completed.

In addition, as another example, the piezoelectric film 15 of the present example includes the rhombohedral domain Db in addition to the c domain Dc, as illustrated in Fig. 4. In this case, in the relationship between the electric field and the amount of strain, the slope changes in two stages, such as a slope from no electric field to E3 and a slope after E3.

In a case where the piezoelectric film 15 includes the a domain Da together with the rhombohedral domain Db, a piezoelectric strain due to the non-180° domain rotation of the rhombohedral domain Db is generated in addition to the normal piezoelectric strain generated in the c domain Dc in a case where the electric field E is applied in the thickness direction. Specifically, in a case of applying the electric field in a direction intersecting the polarization direction P in the rhombohedral domain Db, the rhombohedral domain Db is subjected to the non-180° domain rotation to the c domain Dc, and a piezoelectric strain associated with the non-180° domain rotation is generated. In addition, after the rotation until the rhombohedral domain Db becomes the c domain Dc by the application of the electric field, the electric field is applied in a direction along the polarization direction, and thus the normal piezoelectric strain is generated. As a result, in the example illustrated in Fig. 3, the amount of change (the slope) in the amount of strain with respect to the electric field changes in two stages. In a case where an electric field is increased from no electric field, a domain rotation from the rhombohedral domain Db to the c domain Dc occurs. In this case, E3 is the electric field strength at which the rotation of the rotatable domain in the piezoelectric film 15 is completed, and in a region exceeding E3, strain displacement associated with the normal piezoelectric strain occurs.

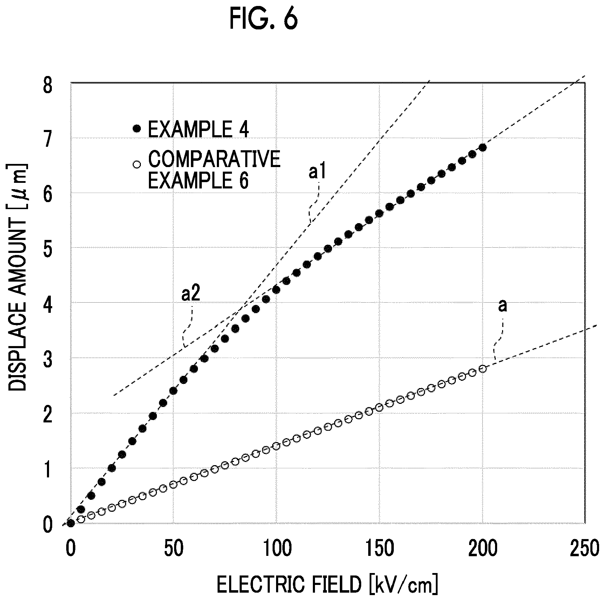

It is noted that although all the changes are indicated by linear lines in Fig. 3 and Fig. 4, the slope gradually changes, and the relationship between the electric field and the amount of strain is the electric field-strain curve (see Example 4 in Fig. 6) in a case where an actual piezoelectric element is measured. Therefore, the slope is indicated by an approximation line. Measuring methods for the electric field and the strain displacement amount will be described in detail in Examples.

It is noted that from the viewpoint of obtaining a large piezoelectric strain in a practical electric field range, the piezoelectric film 15 preferably has a characteristic that a slope changes in the electric field-strain curve that shows the relationship between the electric field and the amount of strain in a case where an electric field of 0 kV/cm to 200 kV/cm is applied in a film thickness direction.

As described above, the piezoelectric element 1 and the piezoelectric laminate 5 of the present example include, on the substrate 10, the lower electrode layer 12, the seed layer 14, and the piezoelectric film 15 in this order. The seed layer 14 consists of a conductive oxide, and the piezoelectric film 15 contains the above-described perovskite-type oxide represented by General Formula I. In the present example, in the perovskite-type oxide satisfying General Formula I, the sum ($y1 + y2$) of the adding amount of the A element added to the A site and the adding amount of the B1 element added to the B site is set to 0.2 times to 0.5 times of the adding amount $x$ of Nb. This makes it possible to suppress an increase in the film stress that occurs in a case where the adding amount of Nb in Nb-PZT is increased. Therefore, it is possible to increase the adding amount of Nb as compared with a case in which the element A and/or the element B1 is not added, and it is possible to realize a piezoelectric film having high piezoelectric characteristics.

In addition, in the present example, the seed layer 14 is provided between the lower electrode layer 12 and the piezoelectric film 15, and the piezoelectric film 15 is formed on the seed layer 14. Therefore, it is possible to effectively suppress the generation of the pyrochlore phase which is easily generated in the initial stage of the formation of the piezoelectric film. As described in the section of "the Related Art", WO2017/085924A or the like discloses that the pyrochlore phase can be suppressed by adding Ni or Sc to Nb-PZT. However, as described in the section of "SUMMARY", according to the study by the inventors of the present invention, there has been a case where the long-term reliability of the piezoelectric element to which Ni or Sc to Nb-PZT is added is not sufficient. The inventors of the present invention have found that the insufficient long-term reliability is due to the pyrochlore phase that is formed at the interface with the lower electrode during the formation of the piezoelectric film. As described in WO2017/085924A and WO2018/042946A, in a case of adding Ni or Sc, the pyrochlore phase is suppressed to such an extent that it is hardly observed in X-ray diffraction. However, the inventors of the present invention have found that in a case where a TEM image of a cross section of the piezoelectric film is observed, the pyrochlore phase is formed at the film formation interface, and in a case where long-term driving is carried out, dielectric breakdown occurs with the pyrochlore phase as a base point. By providing the seed layer 14, the piezoelectric film 15 can be grown in an epitaxial-like manner with respect to the seed layer 14, and thus the generation of the pyrochlore phase can be suppressed.

As described in the section of "Related Art", Nb-PZT has a configuration in which the improvement of the piezoelectric constant is achieved by adding Nb to PZT to cause a large piezoelectric strain associated with the non-180° domain rotation. The reason why, in Nb-PZT, the piezoelectric characteristics are enhanced by adding Nb is that the addition of Nb relatively increases the a-domain Da or the rhombohedral domain Db in the piezoelectric film 15, which easily causes the reversible non-180° domain rotation and easily causes the non-180° domain rotation with a small electric field strength. On the other hand, in the seed layer 14, the crystallinity of the piezoelectric film 15 is enhanced, and the c-domain subjected to the (001) plane alignment is relatively increased. Therefore, it is conceivable that in a case of providing the seed layer 14, it is possible to suppress the generation of the pyrochlore phase, while the non-180° domain rotation is suppressed, whereby the piezoelectric strain due to the non-180° domain rotation is suppressed. On the other hand, the inventors of the present invention have found that in a case of adding the A element and/or the B element of an adding amount of 0.2 times to 0.5 times with respect to the adding amount $x$ of N, high piezoelectric characteristics can be still obtained without suppressing the non-180° domain rotation due to the addition of Nb even in a case where the seed layer 14 is provided (see Examples below). In the piezoelectric element 1 and the piezoelectric laminate 5 of the present example, due to the configuration in which General Formula I is satisfied and the seed layer 14 is provided, it is possible to achieve both an increase in piezoelectric strain associated with the reversible non-180° domain rotation, which occurs by increasing the a domain Da or rhombohedral domain Db of the piezoelectric film 15, and the suppression of the pyrochlore phase which is generated due to improving crystallinity. As a result, the piezoelectric element 1 and the piezoelectric laminate 5 have high piezoelectric characteristics and have high long-term stability.

It is noted that in a case where the seed layer 14 that improves the crystallinity of the piezoelectric film 15 is a dielectric or an insulator, which has low piezoelectric characteristics as compared with the piezoelectric film 15, piezoelectric characteristics of the piezoelectric element deteriorates as compared with a case where the seed layer 14 is not provided. However, in the present example, since the seed layer 14 is a conductive oxide, the seed layer 14 functions in the piezoelectric element as an electrode together with the lower electrode layer 12 at the time when an electric field is applied to the piezoelectric film 15, and thus the deterioration of the piezoelectric characteristics can be suppressed.

The piezoelectric element 1 or the piezoelectric laminate 5 according to each of the above embodiments can be applied to an ultrasonic device, a mirror device, a sensor, or a memory.

Examples

Hereinafter, specific examples and comparative examples of the piezoelectric element according to the present invention will be described. First, a manufacturing method for a piezoelectric element of each example will be described. A radio frequency (RF) sputtering apparatus was used in the formation of the film of each layer.

Formation of film of intimate attachment layer

As a substrate, a thermal oxide film-attached silicon substrate was used. A TiW layer having a thickness of 50 nm was formed on the substrate as an intimate attachment layer under the following film forming conditions. The substrate and the intimate attachment layer were common to all Examples and Comparative Examples.

Sputtering conditions for TiW layer

Distance between target and substrate: 100 mm
Target input power: 600 W
Ar gas pressure: 0.5 Pa
Substrate set temperature: 350°C

Formation of film of lower electrode layer

An Ir layer or Pt layer having a thickness of 150 nm was formed on the TiW layer as a lower electrode layer under the following sputtering conditions. The configuration of the lower electrode layer in each of Examples and Comparative Examples is as shown in Table 1 below.

Sputtering conditions for Ir layer and Pt layer

Distance between target and substrate: 100 mm
Target input power: 600 W
Ar gas pressure: 0.1 Pa
Substrate set temperature: 350°C

Formation of film of seed layer

An $SrRuO_3$ (SRO) layer or $LaNiO_3$ (LNO) layer having a thickness of 200 nm was continuously formed on the lower electrode layer, as a seed layer. An SRO target was used for the formation of the film of the SRO layer, and an LNO target was used for the formation of the film of the LNO layer, both of which were formed under the following sputtering conditions. The seed layer in each of Examples and Comparative Examples is as shown in Table 1 below. It is noted that in Comparative Examples 1 to 5, no seed layer was formed.

Sputtering conditions for SRO layer and LNO layer

Distance between target and substrate: 100 nm
Target input power: 200 W
Vacuum degree: 0.3 Pa, an $Ar/O_2$ mixed atmosphere ($O_2$ volume fraction: 10%)
Substrate set temperature: 450°C

Formation of piezoelectric film

A substrate attached with the lower electrode layer and the seed layer, or a substrate attached with the lower electrode layer was placed in an RF sputtering apparatus, and a piezoelectric film having a thickness of 2 μm was formed into a film under the following sputtering conditions. Regarding the piezoelectric film, the amount of Nb added to PZT, the addition or no addition of any one of Ni, Sc, Co, or La as an additional element, and the adding amount thereof are as shown in Table 1 below. A PZT sintered body target for forming the piezoelectric film having the adding amount of Nb and the adding amount of the additional element, shown in each of Examples and Comparative Examples in Table 1, was prepared. The amount of Pb in the target was set to be larger than the stoichiometric composition, and the Ti/Zr molar ratio was set to the MPB composition (Ti/Zr = 52/48). The adding amount of Nb and the adding amount of the additional element in Table 1 were substantially equal to the contents thereof in the target.

Sputtering conditions for piezoelectric film

Distance between target and substrate: 60 mm
Target input power: 500 W
Vacuum degree: 0.3 Pa, an Ar/O$_2$ mixed atmosphere (O$_2$ volume fraction: 10.0%)
Substrate set temperature: 700°C

Formation of film of upper electrode layer

Next, the substrate 10 after forming the piezoelectric film 15 was placed in a film forming chamber of the RF sputtering apparatus, and by using an indium tin oxide (ITO) target, an ITO layer was formed into a film having a thickness of 200 nm as the upper electrode layer 18. It is noted that before the formation of the film of the upper electrode layer 18, a lift-off pattern for an evaluation sample was prepared on the piezoelectric film 15, and the upper electrode layer 18 was formed on the lift-off pattern. The film forming conditions for the upper electrode layer 18 were as follows.

Sputtering conditions for upper electrode layer

Distance between target and substrate: 100 mm
Target input power: 200 W
Vacuum degree: 0.3 Pa, an Ar/O$_2$ mixed gas (O$_2$ volume fraction: 5%)
Substrate set temperature: room temperature (RT)

Formation of electrode pattern for evaluation

After the formation of the upper electrode layer 18, the upper electrode layer was lifted off along the lift-off pattern according to the lift-off method to carry out the patterning of the upper electrode layer 18.
Through the above steps, the piezoelectric laminated substrate of each example, having the lower electrode layer, the piezoelectric film, and the patterned upper electrode layer on the substrate, was produced.

Production of evaluation sample

Evaluation sample 1

A strip-shaped portion of 2 mm × 25 mm was cut out from the piezoelectric laminated substrate to prepare a cantilever as an evaluation sample 1.

Evaluation sample 2

A portion of 10 mm × 25 mm having, at the center of the surface of the piezoelectric film, an upper electrode layer that had been patterned in a circular shape having a diameter of 400 μm, was cut out from the piezoelectric laminated substrate and used as an evaluation sample 2.

Evaluation of piezoelectric characteristics

The piezoelectric constant $d_{31}$ was measured for the evaluation of the piezoelectric characteristics of each of Examples and Comparative Examples.

The piezoelectric constant $d_{31}$ was measured according to the method described in I. Kanno et. al. Sensor and Actuator A 107 (2003) 68, where the cantilever of the evaluation sample 1 was used, the lower electrode layer was grounded, and the application voltage of sine wave of -10 V $\pm$ 10 V was applied to the upper electrode layer. Table 2 shows the measurement results for each of Examples and Comparative Examples.

Measurement of electric field-strain characteristics

The electric field-strain characteristics were measured for each of Examples and Comparative Examples. A voltage was applied between the lower electrode layer and the upper electrode layer in the same manner as in the evaluation of the piezoelectric characteristics, and the displacement amount of the cantilever with respect to the applied voltage was measured. The relationship between the electric field (= voltage/film thickness of piezoelectric film) and the displacement amount of the cantilever was shown graphically as electric field-strain characteristics.

From the acquired graph of the electric field-displacement amount, it was checked whether or not there was a change in the slope. The evaluation results are shown in Table 2.

Measurement data for Example 4 and Comparative Example 6 are shown in Fig. 6. The relationship between the electric field and the displacement amount in Example 4 is indicated by a slope a1 on the low electric field side and indicated by a slope a2 on the high electric field side. That is, a characteristic that the slope changes in the electric field-strain (displacement amount) characteristic is provided. In this way, in the case where the slope of the electric field-strain characteristics changed in an electric field range of 0 kV/cm to 200 kV/cm, the evaluation was made such that the change is "Present". The relationship between the electric field and the displacement amount in Comparative Example 6 is indicated by one slope a over an electric field range of 0 kV/cm to 200 kV/cm. In this case, the presence or absence of a change in the slope in the electric field-strain characteristics was evaluated as "Absent".

Evaluation of withstand voltage

The withstand voltage (the dielectric breakdown voltage) of each of Examples and Comparative Examples was measured. Using the evaluation sample 2, the lower electrode layer was grounded, a negative voltage was applied to the upper electrode layer at a rate of change of -1 V/sec, and a voltage at which a current of 1 mA or more flowed was regarded as the withstand voltage. Ten samples were prepared for each example, the measurements were carried out a total of 10 times, and an average value (in terms of absolute value) therefrom is shown in Table 2 as the withstand voltage [V].

Evaluation of drive stability (long-term reliability)

A time dependent dielectric breakdown (TDDB) test was carried out as an evaluation of the drive stability of each of Examples and Comparative Examples. Using the evaluation sample 2, in an environment of 120°C, the lower electrode layer was grounded, a voltage of -40 V was applied to the upper electrode layer, and the time (hr) taken from the start of the voltage application to the occurrence of dielectric breakdown was measured. The measurement results are shown in Table 2. It is noted that the TDDB test was carried out for 1,000 hours, and those in which dielectric breakdown did not occur up to 1,000 hours are described as 1,000 in Table 2.

Evaluation of pyrochlore phase thickness

For Examples and Comparative Examples, a transmission electron microscope (TEM) image was taken, and the thickness of the pyrochlore phase was determined from the TEM image. In the piezoelectric film, the contrast in the TEM image differs between the pyrochlore phase and the perovskite phase, and thus it is possible to specify the region of the pyrochlore phase and calculate the thickness thereof. It is noted that it was observed that columnar crystal bodies of the perovskite-type oxide were formed in the portion of the piezoelectric film other than the pyrochlore phase. The thickness of the pyrochlore phase was calculated as an average thickness since the pyrochlore phase was not uniformly formed on the surface of the lower electrode layer.

Specifically, the contrast adjustment function of the image processing software is used to binarize the original image at a predetermined threshold value, and the edge extraction function of the image processing software is used to extract the pyrochlore phase. In this case, the threshold value is such that noise is removed as much as possible and only those that can be clearly distinguished from the pyrochlore phase are extracted. In a case where the outline of the pyrochlore-type oxide layer is unclear in the binarized image, the outline is empirically drawn while looking at the binarized image, and the inside thereof is filled. The area of the extracted pyrochlore phase is calculated from the number of pixels obtained from the image processing software and divided by the visual field width of the TEM image to obtain the average layer thickness. As the image processing software, Photoshop (registered trade name) was used here. Table 2 shows the thickness of the pyrochlore phase obtained as described above.

Evaluation of substrate stress

The film stress was measured using a thin film stress measuring apparatus FLX manufactured by Toho Technology Corp. The amounts of warping of the laminate before and after the formation of the film of the piezoelectric film were measured, and the film stress of the piezoelectric film was calculated from the change in the amount of warping.

Table 1 shows the layer configurations of the piezoelectric element of each of Examples and Comparative Examples, and Table 2 shows the evaluation results of the piezoelectric element of each of Examples and Comparative Examples.

Table 1

|  | Lower electrode | | Seed layer | | Piezoelectric film | | |
|---|---|---|---|---|---|---|---|
|  | Lower electrode | Thickness [nm] | Kind | Thickness [nm] | Adding amount of Nb [% by mole] | Additional element | Adding amount of additional element [% by mole] |
| Comparative Example 1 | Ir | 150 | Absent | Absent | 5 | Absent | Absent |
| Comparative Example 2 | Ir | 150 | Absent | Absent | 10 | Absent | Absent |
| Comparative Example 3 | Ir | 150 | Absent | Absent | 15 | Absent | Absent |
| Comparative Example 4 | Ir | 150 | Absent | Absent | 20 | Absent | Absent |
| Comparative Example 5 | Ir | 150 | Absent | Absent | 20 | Sc | 6 |
| Comparative Example 6 | Ir | 150 | SRO | 50 | 5 | Absent | Absent |
| Comparative Example 7 | Ir | 150 | SRO | 50 | 5 | Sc | 1.5 |
| Comparative Example 8 | Ir | 150 | SRO | 50 | 5 | Ni | 1.5 |
| Comparative Example 9 | Ir | 150 | SRO | 50 | 5 | La | 1.5 |
| Comparative Example 10 | Ir | 150 | SRO | 50 | 5 | Sc | 5 |
| Comparative Example 11 | Ir | 150 | SRO | 50 | 20 | Sc | 2 |
| Comparative Example 12 | Ir | 150 | SRO | 50 | 20 | Sc | 15 |
| Example 1 | Ir | 150 | SRO | 50 | 10 | Sc | 3 |
| Example 2 | Ir | 150 | SRO | 50 | 15 | Sc | 4.5 |
| Example 3 | Ir | 150 | SRO | 50 | 20 | Sc | 4 |
| Example 4 | Ir | 150 | SRO | 50 | 20 | Sc | 6 |
| Example 5 | Ir | 150 | SRO | 50 | 20 | Sc | 10 |
| Example 6 | Ir | 150 | SRO | 50 | 6 | Sc | 2 |

(continued)

| | Lower electrode | | Seed layer | | Piezoelectric film | | |
|---|---|---|---|---|---|---|---|
| | Lower electrode | Thickness [nm] | Kind | Thickness [nm] | Adding amount of Nb [% by mole] | Additional element | Adding amount of additional element [% by mole] |
| Example 7 | Ir | 150 | SRO | 50 | 25 | Sc | 7.5 |
| Example 8 | Ir | 150 | SRO | 50 | 30 | Sc | 9 |
| Example 9 | Ir | 150 | SRO | 50 | 20 | Co | 6 |
| Example 10 | Ir | 150 | LNO | 50 | 10 | Sc | 3 |
| Example 11 | Ir | 150 | LNO | 50 | 15 | Sc | 4.5 |
| Example 12 | Ir | 150 | LNO | 50 | 20 | Sc | 6 |
| Example 13 | Ir | 150 | SRO | 50 | 10 | Ni | 3 |
| Example 14 | Ir | 150 | SRO | 50 | 15 | Ni | 4.5 |
| Example 15 | Ir | 150 | SRO | 50 | 20 | Ni | 6 |
| Example 16 | Ir | 150 | SRO | 50 | 10 | La | 3 |
| Example 17 | Ir | 150 | SRO | 50 | 15 | La | 4.5 |
| Example 18 | Ir | 150 | SRO | 50 | 20 | La | 6 |
| Example 19 | Pt | 150 | SRO | 50 | 10 | Sc | 3 |
| Example 20 | Pt | 150 | SRO | 50 | 15 | Sc | 4.5 |
| Example 21 | Pt | 150 | SRO | 50 | 20 | Sc | 6 |
| Example 22 | Pt | 150 | LNO | 50 | 10 | Sc | 3 |
| Example 23 | Pt | 150 | LNO | 50 | 15 | Sc | 4.5 |
| Example 24 | Pt | 150 | LNO | 50 | 20 | Sc | 6 |

Table 2

| | Presence or absence of change in slope in electric field-strain characteristics | Pyrochlore phase thickness [nm] | Piezoelectric constant $d_{31}$ [pm/V] | Withstand voltage [V] | TDDB [h] | Film stress [Mpa] |
|---|---|---|---|---|---|---|
| Comparative Example 1 | Present | 50 | 150 | 100 | 1000 | 80 |
| Comparative Example 2 | Present | 100 | 180 | 80 | 1000 | 120 |
| Comparative Example 3 | Present | 120 | 200 | 60 | 500 | 170 |
| Comparative Example 4 | - | 200 | - | - | - | - |
| Comparative Example 5 | Present | 200 | 260 | 30 | 200 | 190 |
| Comparative Example 6 | Absent | 0 | 130 | 100 | 1000 | 80 |
| Comparative Example 7 | Absent | 0 | 130 | 100 | 1000 | 90 |
| Comparative Example 8 | Absent | 0 | 130 | 100 | 1000 | 90 |
| Comparative Example 9 | Absent | 0 | 130 | 100 | 1000 | 90 |
| Comparative Example 10 | Absent | 0 | 130 | 100 | 600 | 90 |
| Comparative Example 11 | Absent | 0 | 100 | 100 | 500 | 200 |
| Comparative Example 12 | Present | 0 | 280 | 80 | 200 | 220 |

(continued)

| | Presence or absence of change in slope in electric field-strain characteristics | Pyrochlore phase thickness [nm] | Piezoelectric constant $d_{31}$ [pm/V] | Withstand voltage [V] | TDDB [h] | Film stress [Mpa] |
|---|---|---|---|---|---|---|
| Example 1 | Present | 0 | 220 | 100 | 1000 | 120 |
| Example 2 | Present | 0 | 250 | 100 | 1000 | 170 |
| Example 3 | Present | 0 | 270 | 100 | 1000 | 200 |
| Example 4 | Present | 0 | 290 | 100 | 1000 | 210 |
| Example 5 | Present | 0 | 300 | 100 | 800 | 220 |
| Example 6 | Present | 0 | 200 | 100 | 1000 | 100 |
| Example 7 | Present | 0 | 300 | 80 | 800 | 230 |
| Example 8 | Present | 0 | 300 | 80 | 800 | 250 |
| Example 9 | Present | 0 | 280 | 100 | 1000 | 210 |
| Example 10 | Present | 0 | 220 | 100 | 1000 | 110 |
| Example 11 | Present | 0 | 250 | 100 | 1000 | 170 |
| Example 12 | Present | 0 | 290 | 100 | 1000 | 220 |
| Example 13 | Present | 0 | 220 | 100 | 1000 | 120 |
| Example 14 | Present | 0 | 250 | 100 | 1000 | 180 |
| Example 15 | Present | 0 | 290 | 100 | 1000 | 210 |
| Example 16 | Present | 0 | 220 | 100 | 1000 | 110 |
| Example 17 | Present | 0 | 240 | 100 | 1000 | 180 |
| Example 18 | Present | 0 | 270 | 100 | 1000 | 220 |
| Example 19 | Present | 0 | 220 | 100 | 1000 | 110 |
| Example 20 | Present | 0 | 250 | 100 | 1000 | 170 |
| Example 21 | Present | 0 | 290 | 100 | 1000 | 210 |
| Example 22 | Present | 0 | 220 | 100 | 1000 | 110 |
| Example 23 | Present | 0 | 250 | 100 | 1000 | 180 |
| Example 24 | Present | 0 | 290 | 100 | 1000 | 200 |

As shown in Table 1, Examples 1 to 24 are piezoelectric elements in which a lower electrode layer, a seed layer of a conductive oxide, and a piezoelectric film are provided in this order on a substrate, where the piezoelectric film is composed of a perovskite-type oxide represented by General Formula. On the other hand, Comparative Examples 1 to 12 do not satisfy the conditions of the piezoelectric film in the piezoelectric laminate according to the present invention, for example, the seed layer is not provided, an additional element other than Nb to PZT is not added, or the adding amount of Nb or the adding amount of the additional element is outside the specified range.

As target values for the practical use, the piezoelectric constant was set to 200 pm/V or more, the TDDB test result in which long-term reliability was exhibited was set to 600 hours or more, and the withstand voltage was set to 80 V or more. All of Examples 1 to 24 cleared the target values, and Comparative Examples 1 to 12 did not clear the target values in at least any of the evaluations of the target values. By satisfying the conditions of the piezoelectric laminate according to the present invention, a piezoelectric element having a high piezoelectric constant and high long-term reliability capable of withstanding practical use was obtained.

As shown in Table 1 and Table 2, in Comparative Examples 1 to 4, the piezoelectric film is Nb-PZT, no additional element is added, and the seed layer is not provided. In Comparative Examples 1 to 3, since Nb is added, it is conceived that there is a change in the slope in the electric field-strain characteristics, and thus a piezoelectric strain associated with the non-180° domain rotation of the domain is generated. In addition, according to Comparative Examples 1 to 3, it is clear that the piezoelectric constant tends to increase as the adding amount of Nb increases. In a case where the adding amount of Nb in Comparative Example 4 was 20% by mole, cracks or the like was formed in the piezoelectric film, and the piezoelectric element did not function in a case where the adding amount of Nb was too large. In the evaluation items in Table 2, "-" indicates that the evaluation was not possible.

Comparative Example 4 and Comparative Example 5 differ only in the presence or absence of the addition of Sc to Nb-PZT. From the comparison between the two, it can be seen that in a case where Nb of a high concentration is added, a piezoelectric film that functions as a piezoelectric element is obtained by adding Sc. In Comparative Example 5, a relatively high piezoelectric constant was obtained. On the other hand, in Comparative Example 5, the withstand voltage and the long-term reliability were low.

Comparative Example 6 has a configuration in which the piezoelectric film is Nb-PZT and includes a seed layer. Comparative Example 1 and Comparative Example 6 differ only in the presence or absence of the seed layer. In Comparative Example 6, the piezoelectric constant was low as compared with Comparative Example 1, and there was no change in the slope in the electric field-strain characteristics. From the results of Comparative Example 6, it is speculated that the non-180° domain rotation of the domain is suppressed by providing the seed layer.

In each of Comparative Examples 7 to 10, Sc, Ni, or La is added as compared with Comparative Example 6. Any piezoelectric constant was the same as in Comparative Example 6, and the piezoelectric strain due to the non-180° domain rotation of the domain could not be obtained. No effect was observed by the addition of Sc or the like.

In Comparative Example 11, as a result of setting the adding amount of Nb to 20% by mole and the adding amount of Sc to 2% by mole, both the piezoelectric constant and the long-term reliability were low.

In Comparative Example 12, as a result of setting the adding amount of Nb to 20% by mole and the adding amount of Sc to 15% by mole, a piezoelectric film having a very high piezoelectric constant could be obtained. On the other hand, in Comparative Example 12, the withstand voltage was low and the long-term reliability was also low. It is conceived that in a case where the adding amount of Sc is too large, the balance of valences is lost and thus the withstand voltage and durability are reduced.

Examples 1 to 8 are examples in which the adding amount of Nb was set to 6% to 30% by mole and Sc of an amount of 2x % by mole or more was added. In Examples 1 to 5, 7, and 8 in which the adding amount of Nb was 10% to 30% by mole, a piezoelectric constant of more than 200 pm/V was obtained. In Examples 2 to 5, 7, and 8 in which the adding amount of Nb was 15% to 30% by mole, a piezoelectric constant of 250 pm/V or more was obtained. In addition, in Examples 2 to 4 in which the adding amount of Nb was 10% to 20% by mole and the adding amount of Sc was 0.2x to 0.3x, a very high piezoelectric constant and long-term reliability were obtained. In Examples 3 to 5, the adding amount of Sc was changed from 0.2x to 0.5x with respect to the adding amount x of Nb. Among these, the highest piezoelectric constant was obtained in Example 5; however, on the other hand, the long-term reliability was low as compared with other Examples. In Example 6 in which the adding amount of Nb was 6% by mole, the piezoelectric constant was low as compared with Examples 1 to 5, 7, and 8. In Examples 7 and 8 in which the adding amount of Nb was 25% by mole or more, although a very high piezoelectric constant was obtained, the withstand voltage and the long-term reliability were low as compared with Examples 1 to 4 and 6.

In Example 9, Co was used instead of Sc as compared with Example 4. Evaluation results that were substantially equal to those of Example 4 were obtained. It is conceived that the same effect can be obtained regarding Co with the same adding amount range as in the case of Sc.

Examples 10 to 12 are examples in which the seed layer in Examples 1, 2, and 4 is changed from SRO to LNO. Evaluation results that were substantially equal to those of Examples 1, 2, and 4 were obtained. That is, substantially the same effect was obtained regardless of whether the seed layer was SRO or LNO.

Examples 13 to 15 are examples in which the additional element in Examples 1, 2, and 4 is changed from Sc to Ni. Evaluation results that were substantially equal to those of Examples 1, 2, and 4 were obtained.

Examples 16 to 18 are examples in which the additional element in Examples 1, 2, and 4 is changed from Sc to La. Evaluation results that were substantially equal to those of Examples 1, 2, and 4 were obtained.

In Examples 1, 2, and 4 in which the additional element was Sc, Examples 9 in which the additional element was Co, Examples 13 to 15 in which the additional element was Ni, and Examples 16 to 18 in which the additional element was La, substantially the same evaluation results were obtained depending on the adding amount of the additional element. From this, it is conceived that the same result can be obtained by combining two or more of Sc, Ni, Co, and La although the additional element is a single element in Examples. For example, it is conceived that instead of adding Sc to 6% by mole, in a case of setting Sc to 2% by mole, Ni to 2% by mole, and Co to 2% by mole, resultantly a total of 6% by mole, the same effect as in the case of adding 6% by mole of Sc is obtained.

Examples 19 to 21 are examples in which the lower electrode layer in Examples 1, 2, and 4 is changed from Ir to Pt. In this case as well, evaluation results that were substantially equal to those of Examples 1, 2, and 4 were obtained. That is, substantially the same effect was obtained regardless of whether the lower electrode layer was Ir or Pt.

Examples 22 to 24 are examples in which the seed layer in Examples 19 to 21 is changed from SRO to LNO. In this case as well, substantially the same evaluation results as in Examples 1, 2, and 4 were obtained.

In Examples described above, Sc, Ni, Co, or La was used as the additional element. However, the same evaluation results can be expected as long as an element that behaves similarly to these is used.

**Claims**

1. A piezoelectric laminate (5) comprising, on a substrate (10) in the following order:

   a lower electrode layer (12);
   a piezoelectric film (15);
   wherein the lower electrode layer (12) includes, as a main component, a metal selected from gold (Au), platinum (Pt), iridium (Ir), titanium (Ti), molybdenum (Mo), tantalum (Ta), aluminum (Al), copper (Cu), silver (Ag), and combinations thereof,
   wherein the piezoelectric film (15) contains a perovskite-type oxide represented by General Formula I,

$$Pb_{1-y2}+_{\alpha}A_{y2}\{(Ti, Zr)_{1-x-y1}Nb_xB1_{y1}\}O_3 \qquad \text{General Formula I}$$

   wherein,

   A is an A site element, which is one or more elements including at least La,
   B1 is a B site element, which is one or more divalent or trivalent elements,
   O is oxygen, and
   x, y1, y2, and $\alpha$ satisfy

$$0.05 < x \leq 0.3,\ 0.2x \leq y1 + y2 \leq 0.5x,\ 0 \leq y1 \leq 0.15,\ 0 \leq y2 \leq 0.15,\ \text{and}\ 0 \leq \alpha \leq 0.2;$$

   and
   a seed layer (14) consisting of a conductive oxide provided between the lower electrode layer and the piezoelectric film.

2. The piezoelectric laminate (5) according to claim 1, wherein the metal is from the platinum group.

3. The piezoelectric laminate (5) according to claim 1 or claim 2, wherein the metal is platinum (Pt) or iridium (Ir).

4. The piezoelectric laminate (5) according to any one of claims 1 to 3, wherein B1 is at least one of Ni, Co, or Sc.

5. The piezoelectric laminate (5) according to any one of claims 1 to 4, wherein the seed layer (14) is cubic crystalline or pseudo-cubic crystalline and has a lattice constant of 0.4 nm or less.

6. The piezoelectric laminate (5) according to any one of claims 1 to 5, wherein the piezoelectric film (15) has crystal aligning properties in which crystals are preferentially aligned in a film thickness direction.

7. The piezoelectric laminate (5) according to any one of claims 1 to 6, wherein in the piezoelectric film (15), an internal stress is a tensile stress in a range of 50 to 250 MPa.

8. The piezoelectric laminate (5) according to any one of claims 1 to 7, wherein the piezoelectric film (15) has a characteristic that a slope changes in electric field-strain characteristics in a case where an electric field of 0 kV/cm to 200 kV/cm is applied in a film thickness direction.

9. The piezoelectric laminate (5) according to any one of claims 1 to 8, wherein the seed layer (14) is $LaNiO_3$ or $SrRuO_3$.

10. A piezoelectric element (1) comprising:

    the piezoelectric laminate (5) according to any one of claims 1 to 9; and
    an upper electrode layer (18) formed on the piezoelectric film (15).

**Patentansprüche**

1. Piezoelektrisches Laminat (5), umfassend auf einem Substrat (10) in der folgenden Reihenfolge:

   eine untere Elektrodenschicht (12);
   einen piezoelektrischen Film (15);
   wobei die untere Elektrodenschicht (12) als eine Hauptkomponente ein Metall, das aus Gold (Au), Platin (Pt), Iridium (Ir), Titan (Ti), Molybdän (Mo), Tantal (Ta),
   Aluminium (Al), Kupfer (Cu), Silber (Ag) und Kombinationen davon ausgewählt wird, enthält,
   wobei der piezoelektrische Film (15) ein Oxid des Perowskit-Typs, das durch allgemeine Formel I dargestellt wird, enthält,

   $$Pb_{1-y2+\alpha}A_{y2}\{(Ti, Zr)_{1-x-y1}Nb_xB1_{y1}\}O_3 \qquad \text{Allgemeine Formel I}$$

   wobei,

   A ein A-Stellenelement ist, das ein oder mehrere Elemente sind, die mindestens La enthalten,
   B1 ein B-Stellenelement ist, das ein oder mehrere divalente oder trivalente Elemente sind,
   O Sauerstoff ist, und
   $x$, $y1$, $y2$ und $\alpha$
   $0,05 < x \leq 0,3$, $0,2x \leq y1 + y2 \leq 0,5x$, $0 \leq y1 \leq 0,15$, $0 \leq y2 \leq 0,15$ und $0 \leq \alpha \leq 0,2$ erfüllen; und
   eine Keimschicht (14), die aus einem leitfähigen Oxid besteht und zwischen der unteren Elektrodenschicht und dem piezoelektrischen Film vorgesehen ist.

2. Piezoelektrisches Laminat (5) nach Anspruch 1, wobei das Metall aus der Platingruppe stammt.

3. Piezoelektrisches Laminat (5) nach Anspruch 1 oder Anspruch 2, wobei das Metall Platin (Pt) oder Iridium (Ir) ist.

4. Piezoelektrisches Laminat (5) nach einem der Ansprüche 1 bis 3, wobei B1 mindestens eines von Ni, Co und Sc ist.

5. Piezoelektrisches Laminat (5) nach einem der Ansprüche 1 bis 4, wobei die Keimschicht (14) kubisch kristallin oder pseudokubisch kristallin ist und eine Gitterkonstante von 0,4 nm oder weniger aufweist.

6. Piezoelektrisches Laminat (5) nach einem der Ansprüche 1 bis 5, wobei der piezoelektrische Film (15) Kristallausrichtungseigenschaften aufweist, bei denen Kristalle bevorzugt in einer Filmdickenrichtung ausgerichtet sind.

7. Piezoelektrisches Laminat (5) nach einem der Ansprüche 1 bis 6, wobei bei dem piezoelektrischen Film (15) eine Eigenspannung eine Zugspannung in einem Bereich von 50 bis 250 MPa ist.

8. Piezoelektrisches Laminat (5) nach einem der Ansprüche 1 bis 7, wobei der piezoelektrische Film (15) eine Eigenschaft aufweist, dass sich eine Steigung hinsichtlich Eigenschaften von elektrischem Feld und Dehnung in einem Fall ändert, in dem ein elektrisches Feld von 0 kV/cm bis 200 kV/cm in einer Filmdickenrichtung angelegt wird.

9. Piezoelektrisches Laminat (5) nach einem der Ansprüche 1 bis 8, wobei die Keimschicht (14) $LaNiO_3$ oder $SrRuO_3$ ist.

10. Piezoelektrisches Element (1), umfassend:

    das piezoelektrische Laminat (5) nach einem der Ansprüche 1 bis 9; und
    eine obere Elektrodenschicht (18), die auf dem piezoelektrischen Film (15) gebildet ist.

**Revendications**

1. Stratifié piézoélectrique (5) comprenant, sur un substrat (10), dans l'ordre suivant :

   une couche d'électrode inférieure (12) ;
   un film piézoélectrique (15) ;
   dans laquelle la couche d'électrode inférieure (12) inclut, comme un composant principal, un métal choisi parmi or (Au), platine (Pt), iridium (Ir), titane (Ti), molybdène (Mo), tantale (Ta), aluminium (Al), cuivre (Cu), argent (Ag) et des combinaisons de ceux-ci,

dans lequel le film piézoélectrique (15) contient un oxyde de type pérovskite représenté par Formule Générale I,

$$Pb_{1-y2+\alpha}A_{y2}\{(Ti, Zr)_{1-x-y1}Nb_xB1_{y1}\}O_3 \qquad \text{Formule Générale I}$$

dans lequel

A est un élément de site A, qui est un ou plusieurs éléments incluant au moins La,
B1 est un élément de site B, qui est un ou plusieurs éléments divalents ou trivalents,
O est de l'oxygène, et
x, y1, y2 et $\alpha$ satisfont
$0,05 < x \leq 0,3$, $0,2x \leq y1 + y2 \leq 0,5x$, $0 \leq y1 \leq 0,15$, $0 \leq y2 \leq 0,15$, et $0 \leq \alpha \leq 0,2$ ; et
une couche de graine (14) constituée d'oxyde conducteur prévue entre la couche d'électrode inférieure et le film piézoélectrique.

2. Stratifié piézoélectrique (5) selon la revendication 1, dans lequel le métal est issu du groupe de platine.

3. Stratifié piézoélectrique (5) selon la revendication 1 ou la revendication 2, dans lequel le métal est de platine (Pt) ou d'iridium (Ir).

4. Stratifié piézoélectrique (5) selon l'une quelconque des revendications 1 à 3, dans lequel B1 est au moins l'un de Ni, Co et Sc.

5. Stratifié piézoélectrique (5) selon l'une quelconque des revendications 1 à 4, dans lequel la couche de graine (14) est cristalline cubique ou pseudo -cubique, et a une constante de réseau de 0,4 nm ou moins.

6. Stratifié piézoélectrique (5) selon l'une quelconque des revendications 1 à 5, dans lequel le film piézoélectrique (15) a des propriétés d'alignement cristallin dans lesquelles des cristaux sont préférentiellement alignés dans une direction d'épaisseur de film.

7. Stratifié piézoélectrique (5) selon l'une quelconque des revendications 1 à 6, dans lequel dans le film piézoélectrique (15), une contrainte interne est une contrainte de traction dans une plage de 50 à 250 MPa.

8. Stratifié piézoélectrique (5) selon l'une quelconque des revendications 1 à 7, dans lequel le film piézoélectrique (15) a une caractéristique qu'une pente change dans des caractéristiques de champ électrique-déformation dans un cas où un champ électrique de 0 kV/cm à 200 kV/cm est appliqué dans une direction d'épaisseur de film.

9. Stratifié piézoélectrique (5) selon l'une quelconque des revendications 1 à 8, dans lequel la couche de graine (14) est $LaNiO_3$ ou $SrRuO_3$.

10. Elément piézoélectrique (1) comprenant :

le stratifié piézoélectrique (5) selon l'une quelconque des revendications 1 à 9 ; et
une couche d'électrode supérieure (18) formée sur le film piézoélectrique (15).

FIG. 1

FIG. 2A

FIG. 2B

NORMAL PIEZOELECTRIC STRAIN

c DOMAIN
E = 0

c DOMAIN
E > 0

PIEZOELECTRIC STRAIN DUE
TO REVERSIBLE NON-180°
DOMAIN ROTATION

a DOMAIN
E = 0

c DOMAIN
E > 0

# FIG. 3

# FIG. 4

# FIG. 5

STRAIN

ELECTRIC FIELD

[RELATED ART]

FIG. 6

**EP 4 307 870 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017085924 A
- WO 2018042946 A
- WO 2015174265 A
- US 20090114875 A1
- US 20160005950 A1

**Non-patent literature cited in the description**

- **I. KANNO**. *Sensor and Actuator A*, 2003, vol. 107, 68